# EUROPEAN PATENT SPECIFICATION

(11) **EP 1 839 951 B1**
(45) Date of publication and mention of the grant of the patent: **24.09.2008**
(21) Application number: 07005494.5
(22) Date of filing: 16.03.2007
(51) Int. Cl.: B60R 11/02

(54) **In-vehicle mount type equipment**
Ausrüstung zur Montage im Fahrzeuginneren
Équipement pour montage à l'intérieur d'un véhicule

(30) Priority: 22.03.2006 JP 2006079101
(43) Date of publication of application: 03.10.2007
(73) Proprietor: CLARION Co., Ltd., Bunkyo-ku, Tokyo 112-8608 (JP)
(72) Inventor: Hara, Kazumi, Bunkyo-ku, Tokyo 112-8608 (JP)
(74) Representative: Glawe, Delfs, Moll

(56) References cited:
- DE-A1- 2 903 176
- JP-A- 8 258 631
- US-A- 5 779 197

## Description

### BACKGROUND OF THE INVENTION

### 1. Field of the Invention

The present invention relates to in-vehicle mount type equipment such as a car audio or the like, and particularly to a technique of securing in-vehicle mount type equipment to a frame-shaped bracket fixed to a vehicle.

### 2. Description of the Related Art

With respect to some in-vehicle mount type equipment used while mounted in a vehicle, particularly audio equipment such as a car audio or the like, the main body of the equipment is inserted into a frame-shaped bracket fixed to a car, and a lock mechanism is provided so as to be engaged with the frame bracket to lock the main body of the equipment, thereby preventing the in-vehicle mount type equipment from being stolen. This type of lock mechanism is generally constructed by an engaging portion provided to the frame-shaped bracket, and an engaging pawl that is provided to the main body of the equipment and is engaged with the engaging portion. Furthermore, the main body of the equipment is provided with a releasing-member inserting hole in which a releasing member is insertable, and the engagement of the engaging pawl is released by the releasing member. Such an equipment according to the preamble of claim 1 is known from JP-A-8-258631, DE-A-29 03 176or US-A-5 779 197, for example.

In this type of in-vehicle mount type equipment, the releasing-member inserting hole is provided every engaging pawl. Therefore, in order for a user or a worker to detach the in-vehicle mount type equipment from the vehicle for the purpose of maintenance or the like, he/she must insert the releasing member into each of the releasing-member inserting holes to release the engagement of each engaging pawl, which makes the equipment detaching work cumbersome.

### SUMMARY OF THE INVENTION

The present invention has been implemented in view of the foregoing situation, and has an object to provide in-vehicle mount type equipment whose main body can be simply detached from a vehicle.

In order to attain the above obj ect, according to the present invention, an in-vehicle mount type equipment according to claim 1 is proposed.

In the in-vehicle mount type equipment, the plurality of engaging pieces of the lock member are arranged so as to extend to the front side of the equipment main body, and an insertion port (21, 22) in which the lock release member is inserted is provided to the bottom side of the equipment main body.

The in-vehicle mount type equipment further comprises a panel (5) provided at the front side of the equipment main body (2), wherein the panel is provided with the insertion port (22) at the bottom side thereof.

According to the present invention, the respective engaging pieces of the lock member are arranged substantially in parallel to each other, and there is provided the guide portion (20) for guiding the lock release member (30) that successively abuts against the respective engaging pieces of the lock member from the direction substantially-perpendicular to the respective engaging pieces to elastically deform the respective engaging pieces. Therefore, the engagement of all the engaging pieces of the lock member can be released by merely manipulating the lock release member only once so that the lock release member is guided by the guide portion.

### BRIEF DESCRIPTION OF THE DRAWINGS

Fig. 1 is a perspective view showing the construction of in-vehicle mount type equipment according to an embodiment of the present invention;
Fig. 2 is a perspective view showing the construction of the main body of equipment;
Fig. 3 is a perspective view showing the construction of a lock member;
Fig. 4 is a diagram showing a release key insertion port; and

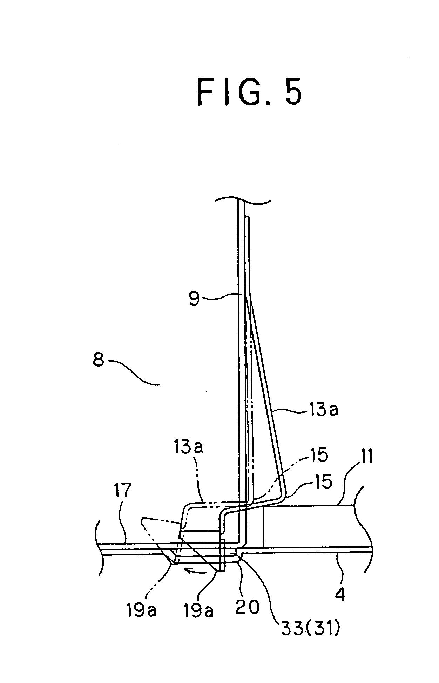

Fig. 5 is a diagram showing a lock state and a lock release state of the lock member.

### DETAILED DESCRIPTION OF THE PREFERRED EMBODIMENT

A preferred embodiment according to the present invention will be described hereunder with reference to the accompanying drawings.

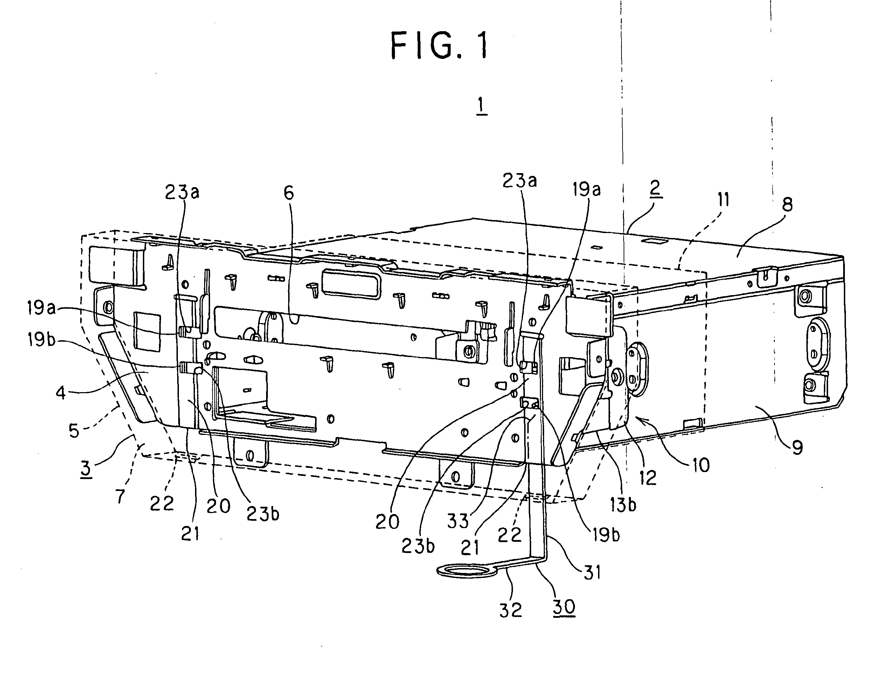

Fig. 1 is a perspective view showing the construction of in-vehicle mount type equipment 1 according to an embodiment. As shown in Fig. 1, the in-vehicle mount type equipment 1 is equipped with the main body 2 of the equipment and a panel 3 disposed at the front side of the equipment main body 2. The panel 3 comprises a panel frame 4 fixed to the front side of the equipment main body 2, and a panel body 5 which is spirally fastened to the panel frame 4. A disk insertion port 6 through which an optical disc such as CD, DVD or the like in which sounds or pictures are recorded is inserted/detached is formed in the panel frame 4 and the panel body 5. Furthermore, a display panel and plural operating members (not shown) are disposed on the panel body 5. The panel frame 4 and the panel body 5 are formed so as to be wider than the lateral width of the equipment main body 2, and an edge portion 7 surrounding the panel frame 4 is provided to the panel body 5.

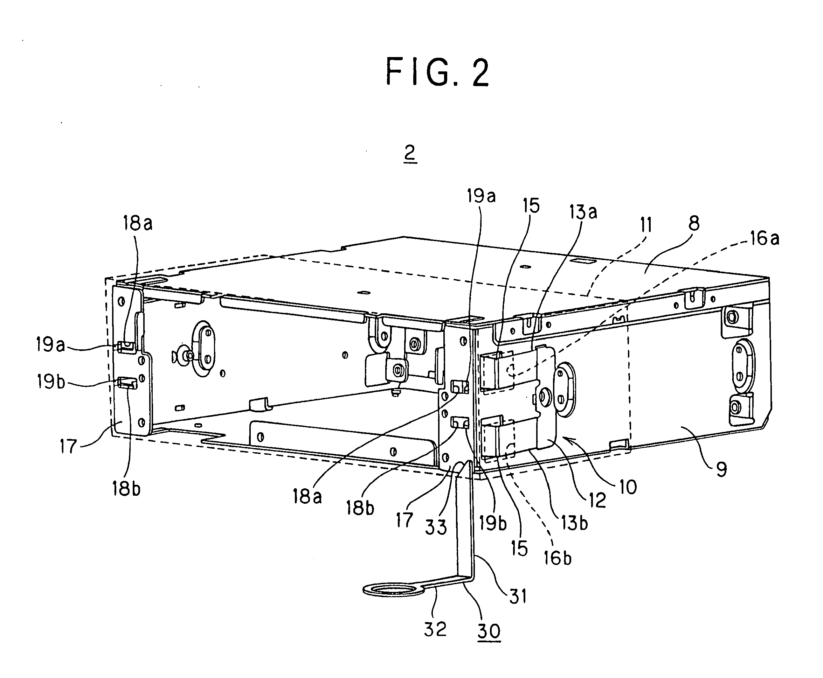

Fig. 2 is a perspective view showing the construction of the equipment main body 2. In Fig. 2, various kinds of mechanisms such as an optical disc driving mechanism, etc. contained in the equipment main body 2 are omitted from the illustration of Fig. 2 to avoid cumbersome illustration of Fig. 2. As shown in Fig. 2, the equipment main body 2 has a main body frame 8 that is opened at the front side thereof and designed to be substantially box-shaped, and lock members 10 disposed at the front sides of the right and left side surfaces 9 of the main body frame 8. The main body frame 8 (equipment main body 2) is accommodated in the frame-shaped bracket 11 fixed to the vehicle.

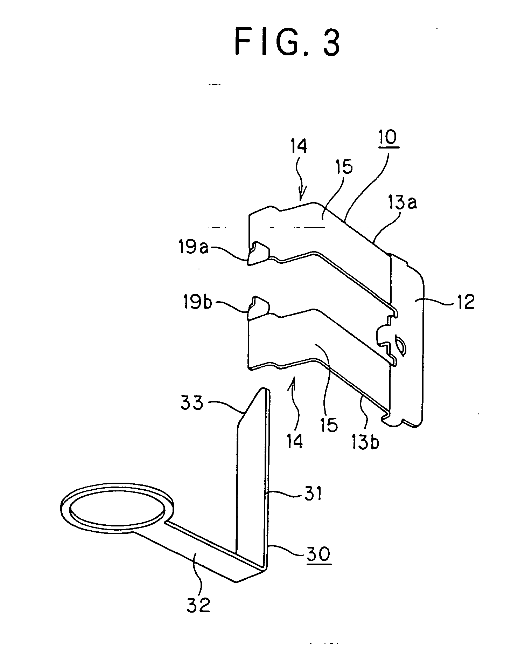

The lock member 10 is equipped with a substantially rectangular fixing portion 12 extending in the up-and-down direction, and lock pawls 13a, 13b that are provided to the upper and lower ends of the fixing portion 12 and extend substantially in parallel to each other in a direction which is substantially perpendicular to the fixing portion 12, and designed in a substantially U-shape as a whole. The lock pawls 13a and 13b are fixed to the main body frame 8 by screws in such an attitude that the lock pawls 13a and 13b extend substantially horizontally to the front side. These lock pawls 13a, 13b are formed of leaf springs, and the tipportions 14 thereof are bent in a substantially L-shape so as to extend inwardly (to the main body frame 8 side) as shown in Figs. 2 and 3, thereby forming engaging projecting portions 15 projecting outwards.

Holes 16a, 16b in which the engaging projecting portions 15 of the lock member 10 are inserted are formed on both the side surfaces of the frame-shapedbracket 11. When the equipment main body 2 is inserted from the opening portion of the frame-shaped bracket 11, the lock pawls 13a, 13b are pressed and deformed inwardly by the fame-shaped bracket 11, and when the equipment main body 2 is inserted to a fixed position, theengagingprojecting portions 15 of the lock pawls 13a 13b are inserted into the holes 16a, 16b of the frame-shapedbracket 11 and returned to the natural state. Under this state, the lock pawls 13a, 13b lock the equipment main body 2 to the frame-shaped bracket 11.

Next, a lock release mechanism of releasing the lock of the equipment main body 2 by the lock pawls 13a, 13b will be described.

As shown in Fig. 2, plate portions 17 are provided to both the right and left sides of the front opening portion of the main body frame 8 by bending the extension portions at the front side of the side walls of the main body frame 8 in a substantially L-shape, and laterally elongated openings 18a, 18b are formed in each plate portion 17 so as to be juxtaposed with each other in the vertical direction. Furthermore, projections 19a, 19b are formed at the tips of the lock pawls 13a, 13b so as to project forwardly from the openings 18a, 18b, and the movement of the projections 19a, 19b in connection with the elastic deformation of the lock pawls 13a, 13b is guided by the openings 18a, 18b. Furthermore, as shown in Fig. 1, guide portions 20 are provided to the panel frame 4 covering the front-side opening of the main body frame 8 so as to traverse the opening portions 18a, 18b formed in the respective plate portions 17.

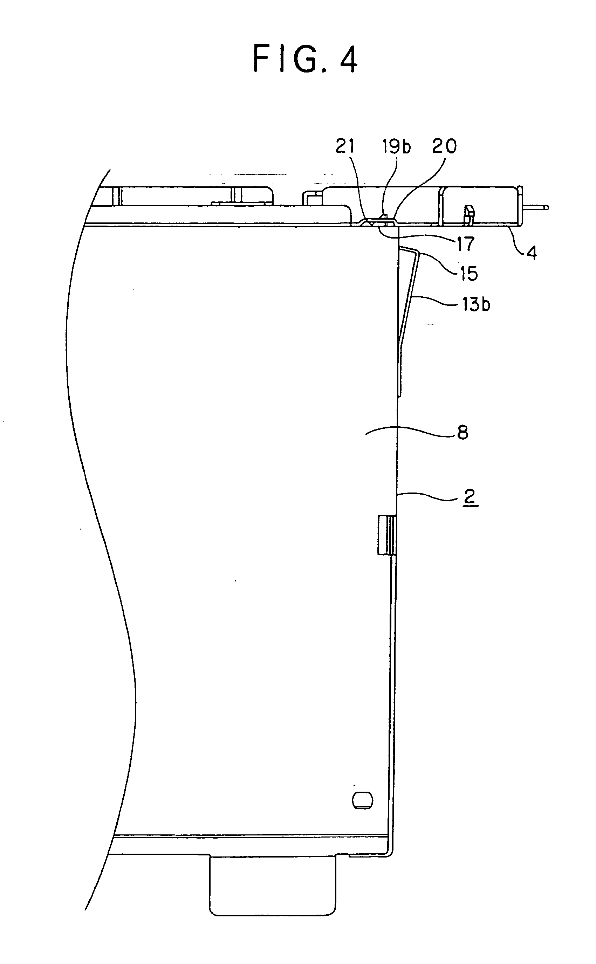

Fig. 4 is a diagram showing a part of the bottom surface of the equipment main body 2 under the state that the panel frame 4 is secured. As shown in Fig. 4, the guide portions 20 are formed by subjecting the panel frame 4 to drawing so as to achieve a substantially U-shaped section, and an insertion port 21 for a release key 30 is formed between each guide portion 20 and each plate portion 17. Furthermore, as shown in Fig. 1, openings 23a, 23b are formed in each guide portion 20 so as to be located at the positions corresponding to the openings 18a, 18b of each plate portion 17, and the projections 19a, 19b of the lock pawls 13a, 13b project from the openings 23a, 23b as shown in Fig. 4.

As shown in Fig. 1, insertion ports 22 for the release key(s)30 are formed at the positions corresponding to the insertion ports 21, that is, at the bottom side of the edge portion 7 of the panel body 5. The release key 30 is inserted from the insertion port 22 into the main body frame 8 and guided by the guide portion 20. The release key 30 comprises a long flat-plate type key body portion 31 guided by the guide portion 20, and a grip portion 32 formed by bending the rear end side of the key body portion 31 in an L-shape. The tip of the key body portion 31 is cut obliquely to form a slope portion 33.

When the lock of the equipment main body 2 is released, the release key 30 is inserted from the bottom side of the equipment main body 2, and directly insert into the guide portion 20. At this time, the tip of the release key 30 successively abuts against the projections 19a, 19b of the lock pawls 13a, 13b, and as indicated by a virtual line, each of the projections 19a, 19b is moved to the equipment main body 2 side along the slope portion at the tip of the release key 30 . Accordingly, the engaging projecting portions 15 of the lock pawls 13a, 13b are successively detached from the holes 16a, 16b of the frame-shaped bracket 11, and all the engagements are released to release the lock, so that the in-vehicle mount equipment 1 can be drawn out of the frame-shaped bracket 11.

Conversely, when the release key 30 is drawn out of the guide portion 20, the projections 19a, 19b are moved to the original positions by the elastic force of the lock paws 13a, 13b, so that the engaging projecting portions 15 intrude into the holes 16a, 16b of the frame-shaped bracket 11 and return to the lock state.

As described above, according to this embodiment, the respective lock pawls 13a, 13b of the lock member 10 are arranged substantially in parallel to each other, and the guide portion 20 is provided to guide the release key 30 so that the release key 30 successively abuts against the lock pawls 13a, 13b from a direction substantially-perpendicular to the lock pawls 13a, 13b of the lock member 10 to elastically deform the lock pawls 13a, 13b, thereby releasing the engagement between the engaging projecting portion 15 and the holes 16a, 16b of the frame-shaped bracket 11. Therefore, a user, a worker or the like can release the engagement of all the lock pawls 13a, 13b of the lock member 10 all at once by manipulating the release key 30 so that the release key 30 is guided by the guide portion 20 only once , thereby simply detaching the in-vehicle mount type equipment.

Furthermore, according to this embodiment, the lock pawls 13a, 13b of the lock member 10 are arranged so as to extend to the front side, and also the insertion port 22 for inserting the release key 30 into the guide portion 20 is provided to the bottom side of the panel body 5, so that the insertion port 22 is hardly viewed from the front side and thus the design performance of the panel body 5 is not spoiled.

## Claims

1. In-vehicle mount type equipment having an equipment main body (2) inserted from an opening portion of a mounting portion fixed to a vehicle and mounted in the mounting portion, and a lock member (10) that is provided to the equipment main body and locks the equipment main body to the mounting portion, wherein the lock member (10) is provided with a plurality of elastically deformable engaging pieces (13a, 13b) that have engaging portions (15) engageable with engaging holes (16a, 16b) formed in the mounting portion and are arranged substantially in parallel to each other, and a guide portion (20) for guiding a lock release member (30) that abuts against the respective engaging pieces of the lock member to elastically deform the respective engaging pieces, thereby releasing the engagement between the engaging portion of each engaging piece and each engaging hole, **characterized in that** the lock release member (30) successively abuts against the respective engaging pieces of the lock member from a direction substantially perpendicular to the respective engaging pieces.

2. The in-vehicle mount type equipment according to claim 1, wherein the plurality of engaging pieces of the lock member are arranged so as to extend to the -front side of the equipment main body, and an insertion port (21, 22) in which the lock release member is inserted is provided to the bottom side of the equipment main body.

3. The in-vehicle mount type equipment according to claim 2, further comprising a panel (5) provided at the front side of the equipment main body (2), wherein the panel is provided with the insertion port (22) at the bottom side thereof.

## Patentansprüche

1. Ausrüstung zur Montage im Fahrzeuginneren mit einem Ausrüstungshauptkörper (2), der von einem Öffnungsteil eines an einem Fahrzeug befestigten Montageteils eingesetzt und in dem Montageteil montiert wird, und einem Sperrelement (10), das an dem Ausrüstungshauptkörper vorgesehen ist und den Ausrüstungshauptkörper an dem Montageteil sperrt, wobei das Sperrelement (10) mit einer Anzahl elastisch formbarer Eingriffsstücke (13a, 13b) versehen ist, die Eingriffsteile (15) haben, welche in Eingriffslöchern (16a, 16b) eingreifen können, die in dem Montageteil ausgebildet und im Wesentlichen parallel zueinander angeordnet sind, und einem Führungsteil (20) zum Führen eines Entsperrelementes (30), das an den jeweiligen Eingriffsstücken des Sperrelementes anschlägt, um die jeweiligen Eingriffsstücke elastisch zu verformen, wodurch der Eingriff zwischen dem Eingriffsteil jedes Eingriffsstückes und jedem Eingriffsloch gelöst wird, **dadurch gekennzeichnet, dass** das Entsperrelement (30) nacheinander an den jeweiligen Eingriffsstücken des Sperrelementes von einer Richtung im Wesentlichen rechtwinkelig zu den jeweiligen Eingriffsstücken her anschlägt.

2. Ausrüstung zur Montage im Fahrzeuginneren nach Anspruch 1, wobei die Anzahl der Eingriffsstücke des Sperrelementes so angeordnet sind, dass sie sich an der Vorderseite des Ausrüstungshauptkörpers erstrecken und an der Unterseite des Ausrüstungshauptkörpers eine Einsetzöffnung (21, 22) vorgesehen ist, in die das Entsperrelement eingesetzt wird.

3. Ausrüstung zur Montage im Fahrzeuginneren nach Anspruch 2, weiterhin mit einer Verkleidung (5), die an der Vorderseite des Ausrüstungshauptkörpers (2) vorgesehen ist, wobei die Verkleidung an ihrer Unterseite mit der Einsetzöffnung (22) versehen ist.

## Revendications

1. Équipement pour montage à l'intérieur d'un véhicule, ayant un corps principal d'équipement (2) introduit à partir d'une partie d'ouverture d'une partie de montage fixée sur un véhicule et monté dans la partie de montage, et un organe de verrouillage (10) qui est prévu sur le corps principal de l'équipement et qui verrouille le corps principal de l'équipement sur la partie de montage, dans lequel l'organe de verrouillage (10) est pourvu d'une pluralité d'éléments d'accrochage élastiquement déformables (13a, 13b) qui ont des parties d'accrochage (15) pouvant s'accrocher avec des trous d'accrochage (16a, 16b) formés dans la partie de montage et qui sont disposés sensiblement parallèlement les uns aux autres, et une partie de guidage (20) destinée à guider un organe de déverrouillage (30) qui vient en butée contre les éléments d'accrochage respectifs de l'organe de verrouillage pour déformer élastiquement les éléments d'accrochage respectifs, libérant ainsi l'accrochage entre la partie d'accrochage de chaque élément d'accrochage et chaque trou d'accrochage, **caractérisé en ce que** l'organe de déverrouillage (30) vient successivement en butée contre les éléments d'accrochage respectifs de l'organe de verrouillage à partir d'une direction sensiblement perpendiculaire aux éléments d'accrochage respectifs.

2. Équipement pour montage à l'intérieur d'un véhicule selon la revendication 1, dans lequel la pluralité d'éléments d'accrochage de l'organe de verrouillage sont disposés de manière à s'étendre jusqu'au côté avant du corps principal de l'équipement, et un orifice d'introduction (21, 22) dans lequel est introduit l'organe de déverrouillage est prévu sur le côté inférieur du corps principal de l'équipement.

3. Équipement pour montage à l'intérieur d'un véhicule selon la revendication 2, comprenant en outre un panneau (5) prévu sur le côté avant du corps principal de l'équipement (2), dans lequel le panneau est prévu avec l'orifice d'introduction (22) sur le côté inférieur de celui-ci.
